# EUROPEAN PATENT SPECIFICATION

(11) **EP 2 383 779 B1**
(45) Date of publication and mention of the grant of the patent: **12.09.2012**
(21) Application number: 10161436.0
(22) Date of filing: 29.04.2010
(51) Int. Cl.: H01L 23/427

(54) **Mounting base**
Montagebasis
Base de montage

(43) Date of publication of application: 02.11.2011
(73) Proprietor: ABB Oy, 00380 Helsinki (FI)
(72) Inventor: Koivuluoma, Timo, 01710, Vantaa (FI); Laurila, Risto, 02620, Espoo (FI)
(74) Representative: Holmström, Stefan Mikael

(56) References cited:
- DE-A1-102004 023 037
- US-A- 3 143 592
- US-A1- 2005 126 760
- US-A1- 2007 175 616
- US-A1- 2007 227 704

## Description

### BACKGROUND OF THE INVENTION

### FIELD OF THE INVENTION

This invention relates to a mounting base for an electric component. More precisely, the invention relates to a mounting base with improved capabilities of conducting heat away from an electric component.

### DESCRIPTION OF PRIOR ART

Previously there is known a solution, where an electric component is attached to a first surface of a mounting base. In order to avoid that heat generated by the electric component during use of said electric component will raise the temperature too much, a second surface of the mounting base is cooled. In this way heat generated by the electric component can be dissipated via the mounting base.

A problem with such a prior art solution is, however, that the heat load is not evenly distributed over the mounting base. Therefore different parts of the base will have different temperatures.

In case the heat load is very local on the first surface of the base, in other words restricted to only a part of the surface area, then the entire dissipation capacity of the second surface can not be efficiently utilized, because of an uneven heat distribution.

DE 10 2004 023 037 discloses a ribbed heat sink structure for cooling computer etc., having heat conducting medium in passages in a baseplate, and radiating fins.

Previously there is also known from US 2003/0155102 A1 a mounting base with a thermosyphon or a planar heat pipe which is used for distributing heat in all directions. Basically this solution consists of a chamber where a fluid boils and condenses. If the chamber is big there may appear a problem in case the pressure inside increases to an extent where the mounting base bulges. In that case an electric component attached to the mounting base may be bent to an extent where damage occurs to the component.

### SUMMARY OF THE INVENTION

An object of the present invention is to solve the above mentioned drawback and to provide an improved mounting base with excellent heat dissipation properties. This object is achieved with the mounting base of claim 1.

Evaporator channels and condenser channels arranged in said mounting base makes it possible to utilize a fluid in the mounting base for receiving and passing on a heat load generated by an electric component. In this way heat is efficiently distributed due to the fluid. Therefore, the dissipation capacity of the second surface of the mounting base can be utilized more efficiently than previously.

Preferred embodiments of the invention are disclosed in the dependent claims.

### BRIEF DESCRIPTION OF DRAWINGS

In the following the present invention will be described in closer detail by way of example and with reference to the attached drawings, in which

Figures 1 to 3 illustrate a first embodiment of a mounting base,

Figure 4 illustrates a second embodiment of a mounting base, and

Figure 5 illustrates fluid distribution in a mounting base.

### DESCRIPTION OF AT LEAST ONE EMBODIMENT

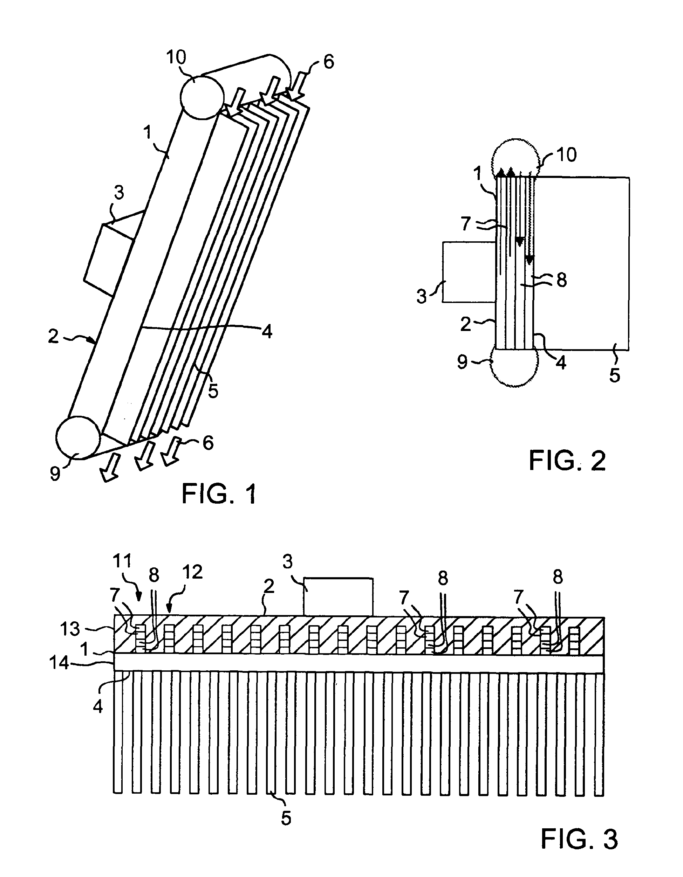

Figures 1 to 3 illustrate a first embodiment of a mounting base 1. Figure 1 is a side view of the mounting base 1, and Figures 2 and 3 are partial cross sections of the mounting base. The illustrated mounting base can be utilized with significant fluid pressures without any bulging that would damage components attached to the mounting base.

The mounting base 1 comprises a first surface 2 for receiving one or more electric components 3 that generate a heat load during use. The same mounting base can be utilized for efficiently cooling a plurality of electric components that can be freely distributed over the first surface 2. When implemented in a drive for an electric motor, such as in a frequency converter, for instance, the electric component (or electric components) may be a power semiconductor. The generated heat load is received by the mounting base 1 via the first surface 2.

The heat load received by the mounting base 1 is dissipated from the mounting base via a second surface 4 of the mounting base 1. Depending on the implementation, this second surface 4 may be provided by an apparatus or shaped in a way which enhances the dissipation. In Figures 1 to 3, it is by way of example assumed that the second surface comprises a heat sink 5 for dissipating heat into air. Instead of a heat sink any fin structure capable of dissipating heat into air may be utilized. The heat sink 5 may additionally include a plurality of fins which pass on heat into the surrounding air. If necessary, in order to increase the cooling capacity, a fan may be utilized in order to generate an airflow 6 between the fins, as illustrated by way of example. The direction of the airflow may be as illustrated, or in the opposite direction.

In order to ensure that the heat load from the electric component 3 is evenly distributed over the surface of the mounting base 1, the mounting base comprises evaporator channels 7, condenser channels 8, a first connecting part 9 and a second connecting part 10 in order to circulate fluid in the mounting base 1.

The evaporator channels 7 are arranged in the vicinity of the first surface 2 to receive the heat load from the electric component 3 via the first surface 2, and to pass the heat load into the fluid in the evaporator channels 7. The second connecting part 10, shown in the upper end of the mounting base 1 in the example of Figures 1 and 2, receives the fluid from the evaporator channels 7 and passes the fluid on into the condenser channels 8.

The condenser channels 8 are arranged in the vicinity of the second surface 4 in order to transfer heat from the fluid in said condenser channels to the second surface 4. The first connecting part 9, shown in the lower end of the mounting base 1 in the example of Figures 1 and 2, receives the fluid from the condenser channels 8 and passes the fluid on into the evaporator channels 9.

In Figures 1 and 2 the mounting base is utilized in a position where the second connecting part 10 is located higher than the first connecting part 9, and the circulation of the fluid will take place due to gravity and condensation/evaporation of the fluid, in a similar way as has been explained in EP - 2 031 332 A1 and EP - 2 119 993 A1, for instance. No pump is therefore needed in order to circulate the fluid. The evaporation in the evaporator channels 7 will cause an upward movement of the fluid in the evaporator channels 7, and the gravity will cause a downward movement of the fluid in the condenser channels 8. Such a circulation can be achieved at least as long as the first connecting part 9 is not located above the level of the second connecting part 10. In that case, the first and second connecting parts 9 and 10 may be designed to pass on fluid from any evaporator channel to any condenser channel and vice versa. Fluid from different evaporator channels and different condenser channels may also be permitted to be mixed up with each other in the first and the second connecting parts before they are passed on.

From Figure 3 it can be seen that the evaporator channels 7 and the condenser channels 8 are grouped together into at least a first group 11 and a second group 12, though the number of groups is 16 in the illustrated example. Each group includes at least one evaporator channel and at least one condenser channel. Such a structure can be accomplished by extruding the mounting base 4 of an aluminum alloy, for instance, in which case the mounting base may consist of a single block having the evaporator channels and the condenser channels formed in it already after the extrusion phase. However, in Figure 3 it is by way of example assumed that the mounting base 1 consists of two plates 13 and 14. The first plate is manufactured with grooves, into which pipes are fitted. The pipes include longitudinal internal walls that separate the evaporator channels and the condenser channels from each other. Finally the second plate 14 is attached to the first plate 13 to finalize the mounting base 1. The first and second plate 13 and 14, the fins of the heat sink 5 and the pipes may be attached to each other by providing a solder on the surfaces of these parts that come into contact with each other. In this way, after the parts have been arranged to contact each other in the illustrated positions, the solder may be melted in an oven, in which case the solder melts and subsequently, when cooled, attaches the parts to each other.

In order to facilitate attachment of the electric component to the mounting base by screws, for instance, some of the evaporator channels of Figure 3 may be omitted. In that case the material thickness of the mounting base is bigger at these locations, which makes it possible to use these locations for attaching said screws, for instance. The solid base material at these attachment locations conducts heat in an reasonable way for short distances, and therefore such attachment locations may be arranged to different parts of the mounting base in advance (before knowing exactly the components and the sizes of the components that will be attached to this particularly mounting base), while only those attachment locations that are actually needed are subsequently taken into use by providing attachment holes into them, for instance. Consequently the attachment of components to the mounting base is very simple and flexible.

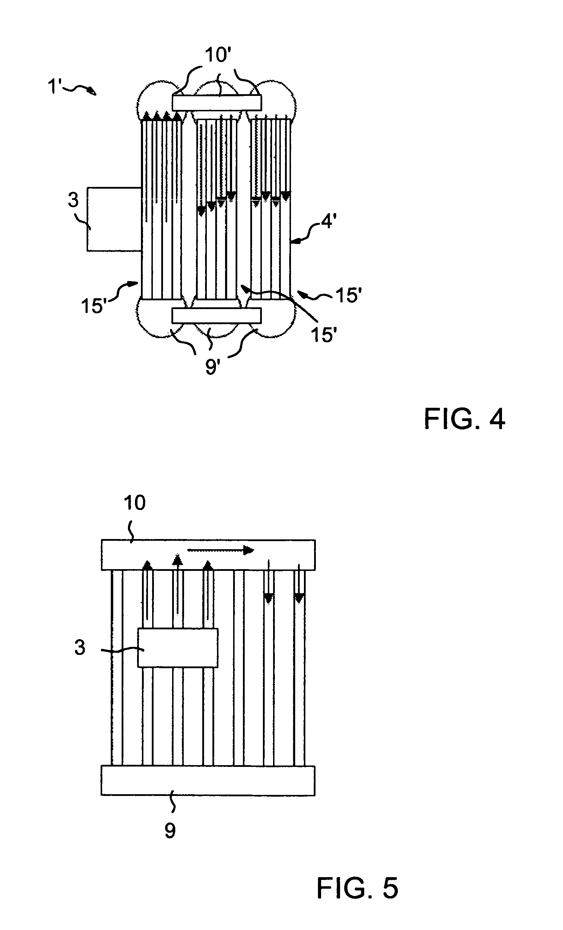

Figure 4 illustrates a second embodiment of a mounting base 1'. The embodiment of Figure 4 is very similar to the one explained in connection with Figures 1 to 3. Therefore, the embodiment of Figure 4 will be explained mainly by pointing out the differences between these embodiments.

In Figure 4, several subsequent pipe structures 15' are utilized. The first and second connecting parts 9' and 10' are designed to pass on fluid between these different pipe structures. Similarly to the previous embodiment, a heat sink may be provided on the second surface 4' of the mounting base 1' for dissipating heat.

Figure 5 illustrates fluid distribution in a mounting base, such as the one illustrated in Figures 1 to 3. In this figure only the electric component 3, the first connecting part 9 and the second connecting part 10 are shown. The evaporator channels and the condenser channels are located on top of each other.

Figure 5 illustrates a situation where the first and second connecting parts 9 and 10 have a structure that allows fluid from different evaporator channels, and correspondingly, different condenser channels to mix up with each other and to be passed on via any one of the condenser channels, and correspondingly, evaporator channels. It can be seen that as the fluid also circulates sideways, the cooling capacity of the entire second surface can be utilized efficiently. In this way the dimensions of the mounting base can be increased both longitudinally and transversally. The spaces between the channels may be dimensioned in such a way that electric or other components may be attached by screws, for instance, in the spaces between the channels.

In the previous explanation the term 'fluid' has been used generally to indicate any medium suitable for use in the described mounting base. The fluid may be a liquid or a gas, and in many implementations, the fluid is in liquid state in certain parts of the mounting base while it is in a gas state in other parts of the mounting base.

## Claims

1. A mounting base (1, 1') for an electric component (3), comprising:
a first surface (2) for receiving the electric component (3) and for receiving a heat load generated by said electric component (3), and
a second surface (4, 4') for dissipating heat from said mounting base,
a first connecting part (9, 9') for passing the fluid from said condenser channels (8) to said evaporator channels (7), and
a second connecting part (10, 10') for passing the fluid from said evaporator channels (7) to the condenser channels (8)
**characterized in that** said mounting base comprises
evaporator channels (7) arranged in the vicinity of said first surface (2) for transferring said received heat load to a fluid in said evaporator channels,
condenser channels (8) in the vicinity of said second surface (4, 4') for transferring heat from the fluid in said condenser channels to said second surface.

2. A mounting base according to claim 1, **characterized in that** said second surface (4, 4') comprises a heat sink (5) or a fins structure for dissipating heat into air.

3. A mounting base according to claim 1 or 2, **characterized in that** said evaporator channels (7) and said condenser channels (8) are grouped together into at least a first group (11) and a second group (12), each group including at least one evaporator channel (7) and at least one condenser channel (8).

4. A mounting base according to claim 3, **characterized in that**
said first connecting part (9, 9') is arranged to conduct fluid from one or more condenser channels (8) of said first group (11) into one or more evaporator channels (7) of said at least first or second group (11, 12), and
said second connecting part (10, 10') is arranged to conduct fluid from one or more evaporator channels (7) of said first group (11) into one or more condenser channels (8) of said at least first or second group (11, 12).

5. A mounting base according to one of claims 1 to 4, **characterized in that** said mounting base (1, 1') is manufactured of an aluminum alloy or a copper alloy.

## Patentansprüche

1. Montagesockel (1, 1') für eine elektrische Komponente (3), folgendes aufweisend:
eine erste Fläche (2) zum Anbringen der elektrischen Komponente (3) und zur Aufnahme von durch die genannte elektrische Komponente (3) erzeugter Wärmelast, und
eine zweite Fläche (4, 4') zum Ableiten von Wärme von dem Montagesockel,
ein erstes Verbindungsteil (9, 9') zum Leiten des Fluids von den genannten Kondensierkanälen (8) zu den genannten Verdampfungskanälen (7), und
ein zweites Verbindungsteil (10, 10') zum Leiten des Fluids von den genannten Verdampfungskanälen (7) zu den Kondensierkanälen (8), **dadurch gekennzeichnet, dass** der genannte Montagesockel folgendes aufweist
Verdampfungskanäle (7) nahe der genannten ersten Fläche (2) zum Übertragen der genannten empfangenen Wärmelast auf ein Fluid in genannten Verdampfungskanälen, und
Kondensierkanäle (8) nahe der zweiten Fläche (4, 4') zum Übertragen von Wärme aus dem Fluid in den genannten Kondensierkanälen zu der genannten zweiten Fläche.

2. Montagesockel gemäß Anspruch 1, **dadurch gekennzeichnet, dass** die genannte zweite Fläche (4, 4') eine Wärmesenke (5) aufweist oder eine Rippenstruktur zur Verteilung von Wärme in Luft.

3. Montagesockel gemäß Anspruch 1 oder 2, **dadurch gekennzeichnet, dass** die genannten Verdampfungskanäle (7) und die genannten Kondensierkanäle (8) zusammengefasst sind in zumindest eine erste Gruppe (11) und eine zweite Gruppe (12), wobei jede Gruppe zumindest einen Verdampfungskanal (7) und zumindest einen Kondensierkanal (8) enthält.

4. Montagesockel gemäß Anspruch 3, **dadurch gekennzeichnet, dass** das genannte erste Verbindungsteil (9, 9') angeordnet ist, um Fluid von einem oder mehreren Kondensierkanälen (8) der genannten ersten Gruppe (11) in einen oder mehrere Verdampfungskanäle (7) der genannten ersten oder zweiten Gruppe (11, 12), zu leiten, und
dass das genannte zweite Verbindungsteil (10, 10') angeordnet ist, um Fluid von einem oder mehreren Verdampfungskanälen (7) der genannten ersten Gruppe (11) in einen oder mehrere Kondensierkanäle (8) der genannten zumindest einen ersten oder zweiten Gruppe (11, 12) zu leiten.

5. Montagesockel gemäß einem der Ansprüche 1 bis 4, **dadurch gekennzeichnet, dass** der Montagesockel (1, 1') aus einer Aluminiumlegierung oder einer Kupferlegierung hergestellt ist.

## Revendications

1. Base de montagne (1, 1') destinée à un composant électrique (3) comprenant :
une première surface (2) pour recevoir le composant électrique (3) et recevoir une charge thermique générée par ledit composant électrique (3) ; et
une seconde surface (4, 4') pour dissiper la chaleur en provenance de ladite base de montage ;
une première partie de connexion (9, 9') pour faire passer le fluide en provenance desdits canaux de condenseur (8) vers lesdits canaux d'évaporateur (7) ; et
une seconde partie de connexion (10, 10') pour faire passer le fluide en provenance desdits canaux d'évaporateur (7) vers lesdits canaux de condenseur (8), **caractérisée en ce que** ladite base de montage comprend ;
des canaux d'évaporateur (7) agencés à proximité de ladite première surface (2) pour transférer ladite charge thermique reçue à un fluide dans lesdits canaux d'évaporateur ;
des canaux de condenseur (8) situés à proximité de ladite seconde surface (4, 4') pour transférer la chaleur en provenance du fluide dans lesdits canaux de condenseur vers ladite seconde surface.

2. Base de montage selon la revendication 1, **caractérisée en ce que** ladite seconde surface (4, 4') comprend un dissipateur thermique (5) ou une structure d'ailettes pour dissiper la chaleur dans l'air.

3. Base de montage selon la revendication 1 ou 2, **caractérisée en ce que** lesdits canaux d'évaporateur (7) et lesdits canaux de condenseur (8) sont regroupés dans au moins un premier groupe (11) et un deuxième groupe (12), chaque groupe comprenant au moins un canal d'évaporateur (7) et au moins un canal de condenseur (8).

4. Base de montage selon la revendication 3, **caractérisée en ce que** :
ladite première partie de connexion (9, 9') est agencée de façon à conduire le fluide en provenance d'un ou de plusieurs canaux de condenseur (8) dudit premier groupe (11) vers un ou plusieurs canaux d'évaporateur (7) dudit au moins premier ou deuxième groupe (11, 12) ; et
ladite seconde partie de connexion (10, 10') est agencée de façon à conduire le fluide en provenance d'un ou de plusieurs canaux d'évaporateur (7) dudit premier groupe (11) vers un ou plusieurs canaux de condenseur (8) dudit au moins premier ou deuxième groupe (11, 12).

5. Base de montage selon l'une quelconque des revendications 1 à 4, **caractérisée en ce que** ladite base de montage (1, 1') est fabriquée à partir d'un alliage d'aluminium ou d'un alliage de cuivre.
